(19) Europäisches Patentamt
European Patent Office
Office européen des brevets

(11) EP 3 916 821 A1

(12) **EUROPEAN PATENT APPLICATION**
published in accordance with Art. 153(4) EPC

(43) Date of publication:
**01.12.2021 Bulletin 2021/48**

(21) Application number: **20744989.3**

(22) Date of filing: **15.01.2020**

(51) Int Cl.:
***H01L 51/44*** *(2006.01)* ***C08K 5/541*** *(2006.01)*
***C08L 65/00*** *(2006.01)* ***H01L 51/46*** *(2006.01)*

(86) International application number:
**PCT/JP2020/000966**

(87) International publication number:
**WO 2020/153180 (30.07.2020 Gazette 2020/31)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **23.01.2019 JP 2019009563**

(71) Applicant: **Nissan Chemical Corporation**
**Tokyo 103-6119 (JP)**

(72) Inventors:
- **SUGAWARA Shun**
**Funabashi-shi, Chiba 274-0052 (JP)**
- **MAEDA Shinichi**
**Funabashi-shi, Chiba 274-0052 (JP)**
- **FUJIHARA Takashi**
**Fukuoka-shi, Fukuoka 814-0001 (JP)**
- **SHIMOI Yuko**
**Fukuoka-shi, Fukuoka 814-0001 (JP)**
- **WANG Pangpang**
**Fukuoka-shi, Fukuoka 814-0001 (JP)**
- **YAHIRO Masayuki**
**Fukuoka-shi, Fukuoka 814-0001 (JP)**

(74) Representative: **Mewburn Ellis LLP**
**Aurora Building**
**Counterslip**
**Bristol BS1 6BX (GB)**

(54) **CHARGE-TRANSPORTING COMPOSITION FOR PEROVSKITE PHOTOELECTRIC CONVERSION ELEMENT**

(57) Provided is a charge-transporting composition for a perovskite photoelectric conversion element, the composition containing: a charge-transporting substance made of a conductive polymer; an organic silane compound; and a solvent.

EP 3 916 821 A1

## Description

### TECHNICAL FIELD

The present invention relates to a charge-transporting composition for a perovskite photoelectric conversion element.

### BACKGROUND ART

An electronic element, particularly an organic photoelectric conversion element is a device that converts light energy into electric energy using an organic semiconductor, and examples thereof include an organic solar cell.

An organic solar cell is a solar cell element using organic matter in an active layer and a charge-transporting substance, and a dye-sensitized solar cell developed by M. Grätzel and an organic thin-film solar cell developed by C. W. Tang are well known (Non-Patent Documents 1 and 2).

Both of them have characteristics different from currently mainstream inorganic solar cells, in that they are lightweight and thin films, thus can be made flexible, they can be produced in a roll-to-roll manner, and the like, and thus are expected to form a new market.

On the other hand, in recent years, research results have been reported that a solar cell using a metal halide as a compound having a perovskite-type crystal structure (hereinafter, referred to as a "perovskite semiconductor compound".) can achieve relatively high photoelectric conversion efficiency, and have attracted attention. For example, Patent Document 1 describes a photoelectric conversion element and solar cell including an active layer containing a perovskite semiconductor compound.

However, in a photoelectric conversion element using a perovskite semiconductor compound in an active layer, stability of the element may decrease depending on the conditions of other layers combined with the active layer, and further improvement is desired.

### PRIOR ART DOCUMENTS

### PATENT DOCUMENTS

Patent Document 1: JP-A 2016-178193

Non-Patent Document 1: Nature, vol. 353, 737-740 (1991)
Non-Patent Document 2: Appl. Phys. Lett., Vol. 48, 183-185 (1986)

### SUMMARY OF INVENTION

### TECHNICAL PROBLEM

The present invention has been made in view of the above circumstances, and an object thereof is to provide a charge-transporting composition that can be suitably used as a hole collecting layer of a perovskite photoelectric conversion element and can provide a perovskite photoelectric conversion element having both high conversion efficiency (PCE) and excellent stability.

### SOLUTION TO PROBLEM

As a result of intensive studies to achieve the above object, the present inventors have found that a perovskite photoelectric conversion element having both high PCE and excellent stability can be obtained by using a composition containing a charge-transporting substance composed of a conductive polymer, an organosilane compound and a solvent in a hole collecting layer of the perovskite photoelectric conversion element, and have completed the present invention.

That is, the present invention provides:

1. A charge-transporting composition for a perovskite photoelectric conversion element including: a charge-transporting substance composed of a conductive polymer; an organosilane compound; and a solvent;
2. The charge-transporting composition for a perovskite photoelectric conversion element according to 1, wherein the conductive polymer is a p-type conjugated homopolymer;
3. The charge-transporting composition for a perovskite photoelectric conversion element according to 1 or 2, wherein

the conductive polymer is a polythiophene derivative;
4. The charge-transporting composition for a perovskite photoelectric conversion element according to any one of 1 to 3, wherein the conductive polymer is a polythiophene derivative containing a repeating unit having formula (1):

[Chem. 1]

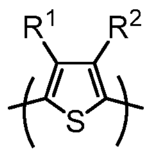

(1)

wherein $R^1$ and $R^2$ are each independently a hydrogen atom, an alkyl group having 1 to 40 carbon atoms, a fluoroalkyl group having 1 to 40 carbon atoms, an alkoxy group having 1 to 40 carbon atoms, a fluoroalkoxy group having 1 to 40 carbon atoms, an aryloxy group having 6 to 20 carbon atoms, $-O-[Z-O]_p-R^e$, or a sulfonic acid group, or are -O-Y-O- formed by bonding $R^1$ and $R^2$, Y is an alkylene group having 1 to 40 carbon atoms which may contain an ether bond and may be substituted with a sulfonic acid group, Z is an alkylene group having 1 to 40 carbon atoms which may be substituted with a halogen atom, p is 1 or more, $R^e$ is a hydrogen atom, an alkyl group having 1 to 40 carbon atoms, a fluoroalkyl group having 1 to 40 carbon atoms, or an aryl group having 6 to 20 carbon atoms;
5. The charge-transporting composition for a perovskite photoelectric conversion element according to any one of 1 to 4, wherein the organosilane compound is alkoxysilane;
6. The charge-transporting composition for a perovskite photoelectric conversion element according to 5, wherein the alkoxysilane contains at least one selected from trialkoxysilane and tetraalkoxysilane;
7. The charge-transporting composition for a perovskite photoelectric conversion element according to any one of 1 to 6, wherein the charge-transporting composition is for a hole collecting layer of a perovskite photoelectric conversion element;
8. The charge-transporting composition according to 7, wherein the perovskite photoelectric conversion element is a solar cell;
9. A thin film obtained from the charge-transporting composition for a perovskite photoelectric conversion element according to any one of 1 to 6;
10. The thin film according to 9, wherein the thin film is a hole collecting layer of a perovskite photoelectric conversion element;
11. A perovskite photoelectric conversion element including the thin film according to 9 or 10;
12. A perovskite photoelectric conversion element including: the hole collecting layer according to 10; and an active layer provided so as to be in contact with the hole collecting layer, the active layer containing a perovskite semiconductor compound;
13. A perovskite photoelectric conversion element including: a pair of electrodes; an active layer provided between the pair of electrodes; and a hole collecting layer provided between the active layer and the electrodes,
the active layer containing a perovskite semiconductor compound, and the hole collecting layer being the thin film according to 10; and
14. A solar cell including the perovskite photoelectric conversion element according to any one of 11 to 13.

## ADVANTAGEOUS EFFECTS OF INVENTION

The charge-transporting composition for a perovskite photoelectric conversion element of the present invention can be suitably employed for formation of a hole collecting layer of a perovskite photoelectric conversion element, and a perovskite photoelectric conversion element having both high PCE and excellent stability can be obtained when a thin film obtained using the composition is used as a hole collecting layer.

## DESCRIPTION OF EMBODIMENTS

Hereinafter, the present invention is described in more detail.
The charge-transporting composition for a perovskite photoelectric conversion element of the present invention contains a charge-transporting substance composed of a conductive polymer, an organosilane compound, and a solvent.
In the present invention, as the conductive polymer, a p-type conjugated homopolymer is preferable, a polythiophene derivative is more preferable, and a polythiophene derivative containing a repeating unit represented by the

following formula (1) is still more preferable, from the viewpoint of exhibiting high PCE in the prepared photoelectric conversion element.

[Chem. 2]

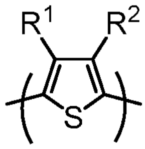

(1)

In the formula (1), $R^1$ and $R^2$ are each independently a hydrogen atom, an alkyl group having 1 to 40 carbon atoms, a fluoroalkyl group having 1 to 40 carbon atoms, an alkoxy group having 1 to 40 carbon atoms, a fluoroalkoxy group having 1 to 40 carbon atoms, an aryloxy group having 6 to 20 carbon atoms, $-O-[Z-O]_p-R^e$, or a sulfonic acid group, or are -O-Y-O- formed by bonding $R^1$ and $R^2$, Y is an alkylene group having 1 to 40 carbon atoms which may contain an ether bond and may be substituted with a sulfonic acid group, Z is an alkylene group having 1 to 40 carbon atoms which may be substituted with a halogen atom, p is an integer of 1 or more, $R^e$ is a hydrogen atom, an alkyl group having 1 to 40 carbon atoms, a fluoroalkyl group having 1 to 40 carbon atoms, or an aryl group having 6 to 20 carbon atoms.

The alkyl group having 1 to 40 carbon atoms may be linear, branched or cyclic, and specific examples thereof include a methyl group, an ethyl group, an n-propyl group, an isopropyl group, an n-butyl group, an isobutyl group, an s-butyl group, a t-butyl group, an n-pentyl group, an n-hexyl group, an n-heptyl group, an n-octyl group, an n-nonyl group, an n-decyl group, an n-undecyl group, an n-dodecyl group, an n-tridecyl group, an n-tetradecyl group, an n-pentadecyl group, an n-hexadecyl group, an n-heptadecyl group, an n-octadecyl group, an n-nonadecyl group, an n-eicosanyl group, a behenyl group, a triacontyl group, a tetracontyl group, and the like, and alkyl groups having 1 to 18 carbon atoms are preferable, and alkyl groups having 1 to 8 carbon atoms are more preferable.

Examples of the fluoroalkyl group having 1 to 40 carbon atoms include groups in which at least one hydrogen atom is substituted with a fluorine atom in the alkyl group having 1 to 40 carbon atoms, and are not particularly limited, and examples thereof include a fluoromethyl group, a difluoromethyl group, a trifluoromethyl group, a perfluoromethyl group, a 1-fluoroethyl group, a 2-fluoroethyl group, a 1,2-difluoroethyl group, a 1,1-difluoroethyl group, a 2,2-difluoroethyl group, a 1,1,2-trifluoroethyl group, a 1,2,2-trifluoroethyl group, a 2,2,2-trifluoroethyl group, a 1,1,2,2-tetrafluoroethyl group, a 1,2,2,2-tetrafluoroethyl group, a perfluoroethyl group, a 1-fluoropropyl group, a 2-fluoropropyl group, a 3-fluoropropyl group, a 1,1-difluoropropyl group, a 1,2-difluoropropyl group, a 1,3-difluoropropyl group, a 2,2-difluoropropyl group, a 2,3-difluoropropyl group, a 3,3-difluoropropyl group, a 1,1,2-trifluoropropyl group, a 1,1,3-trifluoropropyl group, a 1,2,3-trifluoropropyl group, a 1,3,3-trifluoropropyl group, a 2,2,3-trifluoropropyl group, a 2,3,3-trifluoropropyl group, a 3,3,3-trifluoropropyl group, a 1,1,2,2-tetrafluoropropyl group, a 1,1,2,3-tetrafluoropropyl group, a 1,2,2,3-tetrafluoropropyl group, a 1,3,3,3-tetrafluoropropyl group, a 2,2,3,3-tetrafluoropropyl group, a 2,3,3,3-tetrafluoropropyl group, a 1,1,2,2,3-pentafluoropropyl group, a 1,2,2,3,3-pentafluoropropyl group, a 1,1,3,3,3-pentafluoropropyl group, a 1,2,3,3,3-pentafluoropropyl group, a 2,2,3,3,3-pentafluoropropyl group, a perfluoropropyl group, a perfluorobutyl group, a perfluoropentyl group, a perfluorohexyl group, a perfluoroheptyl group, a perfluorooctyl group, and the like.

As the alkoxy group having 1 to 40 carbon atoms, an alkyl group therein may be linear, branched or cyclic, and examples thereof include a methoxy group, an ethoxy group, an n-propoxy group, an i-propoxy group, a c-propoxy group, an n-butoxy group, an i-butoxy group, an s-butoxy group, a t-butoxy group, an n-pentoxy group, an n-hexoxy group, an n-heptyloxy group, an n-octyloxy group, an n-nonyloxy group, an n-decyloxy group, an n-undecyloxy group, an n-dodecyloxy group, an n-tridecyloxy group, an n-tetradecyloxy group, an n-pentadecyloxy group, an n-hexadecyloxy group, an n-heptadecyloxy group, an n-octadecyloxy group, an n-nonadecyloxy group, an n-eicosanyloxy groups, and the like.

The fluoroalkoxy group having 1 to 40 carbon atoms is not particularly limited as long as it is an alkoxy group in which at least one hydrogen atom on a carbon atom is substituted with a fluorine atom, and examples thereof include a fluoromethoxy group, a difluoromethoxy group, a trifluoromethoxy group, a 1-fluoroethoxy group, a 2-fluoroethoxy group, a 1,2-difluoroethoxy group, a 1,1-difluoroethoxy group, a 2,2-difluoroethoxy group, a 1,1,2-trifluoroethoxy group, a 1,2,2-trifluoroethoxy group, a 2,2,2-trifluoroethoxy group, a 1,1,2,2-tetrafluoroethoxy group, a 1,2,2,2-tetrafluoroethoxy group, a 1,1,2,2,2-pentafluoroethoxy group, a 1-fluoropropoxy group, a 2-fluoropropoxy group, a 3-fluoropropoxy group, a 1,1-difluoropropoxy group, a 1,2-difluoropropoxy group, a 1,3-difluoropropoxy group, a 2,2-difluoropropoxy group, a 2,3-difluoropropoxy group, a 3,3-difluoropropoxy group, a 1,1,2-trifluoropropoxy group, a 1,1,3-trifluoropropoxy group, a 1,2,3-trifluoropropoxy group, a 1,3,3-trifluoropropoxy group, a 2,2,3-trifluoropropoxy group, a 2,3,3-trifluoropropoxy group, a 3,3,3-trifluoropropoxy group, a 1,1,2,2-tetrafluoropropoxy group, a 1,1,2,3-tetrafluoropropoxy group, a 1,2,2,3-tetrafluoropropoxy group, a 1,3,3,3-tetrafluoropropoxy group, a 2,2,3,3-tetrafluoropropoxy group, a 2,3,3,3-tetrafluoropropoxy group, a 1,1,2,2,3-pentafluoropropoxy group, a 1,2,2,3,3-pentafluoropropoxy group, a 1,1,3,3,3-pentafluoropropoxy group, a 1,2,3,3,3-pentafluoropropoxy group, a 2,2,3,3,3-pentafluoropropoxy group, a heptafluoropropoxy group, and the like.

The alkylene group having 1 to 40 carbon atoms may be linear, branched or cyclic, and examples thereof include a methylene group, an ethylene group, a propylene group, a trimethylene group, a tetramethylene group, a pentylene group, a hexylene group, a heptylene group, an octylene group, a nonylene group, a decylene group, an undecylene group, a dodecylene group, a tridecylene group, a tetradecylene group, a pentadecylene group, a hexadecylene group, a heptadecylene group, an octadecylene group, a nonadecylene group, an eicosanylene group, and the like.

Examples of the aryl group having 6 to 20 carbon atoms include a phenyl group, a tolyl group, a 1-naphthyl group, a 2-naphthyl group, a 1-anthryl group, a 2-anthryl group, a 9-anthryl group, a 1-phenanthryl group, a 2-phenanthryl group, a 3-phenanthryl group, a 4-phenanthryl group, a 9-phenanthryl group, and the like, and a phenyl group, a tolyl group, and a naphthyl group are preferable.

Examples of the aryloxy group having 6 to 20 carbon atoms include a phenoxy group, an anthracenoxy group, a naphthoxy group, a phenanthrenoxy group, a fluorenoxy group, and the like.

Examples of the halogen atom include a fluorine atom, a chlorine atom, a bromine atom, and an iodine atom.

In the polythiophene derivative containing a repeating unit represented by the formula (1), one in which $R^1$ and $R^2$ are each independently a hydrogen atom, a fluoroalkyl group having 1 to 40 carbon atoms, an alkoxy group having 1 to 40 carbon atoms, $-O[C(R^aR^b)-C(R^cR^d)-O]_p-R^e$, $-OR^f$, or a sulfonic acid group, or are -O-Y-O- formed by bonding $R^1$ and $R^2$ is preferable. $R^a$ to $R^d$ each independently represent a hydrogen atom, an alkyl group having 1 to 40 carbon atoms, a fluoroalkyl group having 1 to 40 carbon atoms, or an aryl group having 6 to 20 carbon atoms. $R^e$ is the same as described above. p is preferably 1, 2, or 3. $R^f$ is preferably an alkyl group having 1 to 40 carbon atoms, a fluoroalkyl group having 1 to 40 carbon atoms, or an aryl group having 6 to 20 carbon atoms.

In the present invention, among them, one in which $R^1$ and $R^2$ are -O-Y-O- formed by bonding $R^1$ and $R^2$ is more preferable.

Examples of a preferred aspect of the polythiophene derivative include an aspect containing a repeating unit in which $R^1$ and $R^2$ are -O-Y-O- formed by bonding $R^1$ and $R^2$.

Examples of still another preferred aspect of the polythiophene derivative include an aspect in which $R^1$ and $R^2$ contain a repeating unit that is a group represented by the following formula (Y1).

[Chem. 3]

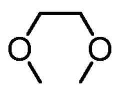

(Y1)

Preferable specific examples of the polythiophene derivative include polythiophene containing a repeating unit represented by the following formula (1-1).

[Chem. 4]

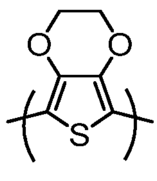

(1-1)

Furthermore, the polythiophene derivative may be a homopolymer or a copolymer (including statistical, random, gradient, and block copolymers). As the polymer containing monomer A and monomer B, the block copolymer includes, for example, an A-B diblock copolymer, an A-B-A triblock copolymer, and an $(AB)_m$-multiblock copolymer. Polythiophene may contain a repeating unit derived from other types of monomers (for example, thienothiophene, selenophene, pyrrole,

furan, tellurophene, aniline, arylamine, arylene (for example, phenylene, phenylenevinylene, fluorene, and the like), and the like).

In the present invention, the content of the repeating unit represented by the formula (1) in the polythiophene derivative is preferably more than 50 wt%, more preferably 80 wt% or more, still more preferably 90 wt% or more, further preferably 95 wt% or more, and most preferably 100 wt%, based on the total weight of the repeating units.

In the present invention, depending on purity of a starting monomer compound used in polymerization, a polymer to be formed may contain a repeating unit derived from impurities. In the present invention, the term "homopolymer" above means a polymer containing a repeating unit derived from one type of monomer, but may also contain a repeating unit derived from impurities. In the present invention, basically, all the repeating units of the polythiophene derivative are preferably a homopolymer which is a repeating unit represented by the formula (1), and more preferably a homopolymer which is a repeating unit represented by the formula (1-1).

The weight average molecular weight of the polythiophene derivative represented by the formula (1) is preferably about 1,000 to 1,000,000, more preferably about 5,000 to 100,000, and still more preferably about 10,000 to about 50,000. By setting the weight average molecular weight to greater than or equal to the lower limit, good conductivity is obtained, and by setting the weight average molecular weight to less than or equal to the upper limit, solubility in a solvent is improved. Meanwhile, the weight average molecular weight is a value in terms of polystyrene by gel permeation chromatography.

In the composition of the present invention, the polythiophene derivative containing a repeating unit represented by the formula (1) may be used alone, or two or more compounds may be used in combination.

In addition, as the polythiophene derivative containing a repeating unit represented by the formula (1), a commercially available product may be used, or a polythiophene derivative polymerized by a known method using a thiophene derivative or the like as a starting material may be used, but in any case, it is preferable to use one purified by a method such as reprecipitation or ion exchange. By using the purified polythiophene derivative, characteristics of a perovskite photoelectric conversion element including a thin film obtained from a composition containing the compound can be further enhanced.

As the organosilane compound, alkoxysilane is preferable, and trialkoxysilane and tetraalkoxysilane are more preferable. Examples of the alkoxysilane include tetraethoxysilane (TEOS), tetramethoxysilane, tetraisopropoxysilane, phenyltriethoxysilane, phenyltrimethoxysilane, methyltriethoxysilane, methyltrimethoxysilane, 3,3,3-trifluoropropyltrimethoxysilane, dimethyldiethoxysilane, dimethyldimethoxysilane, and the like. In the present invention, among them, TEOS, tetramethoxysilane, and tetraisopropoxysilane can be suitably used. These organosilane compounds can be used singly or in combination of two or more kinds thereof.

The compounding amount of the organosilane compound is preferably 0.1 to 10 times, more preferably 0.5 to 7 times, and still more preferably 1.0 to 5 times in terms of a weight ratio with respect to the conductive polymer, or with respect to the total amount of the conductive polymer and an electron accepting dopant substance when the electron accepting dopant substance described later is contained. By setting the compounding amount of the organosilane compound within the above ranges, stability of photoelectric conversion element to be obtained can be improved.

In the perovskite photoelectric conversion element, an ionization potential of a hole collecting layer is preferably a value close to an ionization potential of a p-type semiconductor material (perovskite semiconductor material) in an active layer. The absolute value of the difference is preferably 0 to 1 eV, more preferably 0 to 0.5 eV, and still more preferably 0 to 0.2 eV. Therefore, the charge-transporting composition of the present invention may contain an electron accepting dopant substance for the purpose of adjusting the ionization potential of the charge-transporting thin film obtained by using this. The electron accepting dopant substance is not particularly limited as long as it dissolves in at least one solvent to be used.

Specific examples of the electron accepting dopant substance include inorganic strong acids such as hydrogen chloride, sulfuric acid, nitric acid, and phosphoric acid; Lewis acids such as aluminum(III) chloride ($AlCl_3$), titanium(IV) tetrachloride ($TiCl_4$), boron tribromide ($BBr_3$), boron trifluoride ether complex ($BF_3 \cdot OEt_2$), iron(III) chloride ($FeCl_3$), copper(II) chloride ($CuCl_2$), antimony(V) pentachloride ($SbCl_5$), arsenic(V) pentafluoride (AsFs), phosphorus pentafluoride ($PF_5$), and tris(4-bromophenyl) aluminum hexachloroantimonate (TBPAH); organic strong acids such as benzenesulfonic acid, tosylic acid, hydroxybenzenesulfonic acid, 5-sulfosalicylic acid, dodecylbenzenesulfonic acid, polystyrenesulfonic acid, and camphorsulfonic acid; and organic oxidants such as 7,7,8,8-tetracyanoquinodimethane (TCNQ), 2,3-dichloro-5,6-dicyano-1,4-benzoquinone (DDQ), and iodine, and among them, polystyrene sulfonic acid is preferable. These may be used alone or in combination of two or more kinds thereof.

In the composition of the present invention, other additives may be blended as long as the object of the present invention can be achieved.

The kinds of additives can be appropriately selected from known ones according to desired effects and used.

As the solvent used for preparing the charge-transporting composition, a highly soluble solvent capable of well dissolving the conductive polymer and the electron accepting dopant substance can be used. The highly soluble solvent can be used singly or in a mixture of two or more kinds thereof, and the amount thereof to be used can be set to 5 to

100 wt% based on the entire solvent to be used in the composition.

Examples of such a highly soluble solvent include water; and organic solvents such as alcohol-based solvents such as ethanol, 2-propanol, 1-butanol, 2-butanol, s-butanol, t-butanol and 1-methoxy-2-propanol, and amide-based solvents such as N-methylfomamide, N,N-dimethylformamide, N,N-diethylformamide, N-methylacetamide, N,N-dimethylacetamide, N-methylpyrrolidone and 1,3-dimethyl-2-imidazolidinone.

Among them, at least one selected from water and alcohol-based solvents is preferable, and water, ethanol or 2-propanol is more preferable.

The charge-transporting substance and the electron accepting dopant substance are both completely dissolved or uniformly dispersed in the solvent.

The solid content concentration of the charge-transporting composition of the present invention is appropriately set in consideration of viscosity, surface tension and the like of the composition, thickness of the thin film to be produced, and the like, but is usually about 0.1 to 20.0 wt%, preferably 0.5 to 15.0 wt%, and more preferably 1.0 to 10.0 wt%. Meanwhile, the solid content of the solid content concentration mentioned herein means components other than the solvent contained in the charge-transporting composition of the present invention.

In addition, the weight ratio of the charge-transporting substance and the electron accepting dopant substance is also appropriately set in consideration of charge transporting properties to be exhibited, the kind of charge-transporting substance, and the like, and is usually 0 to 10, preferably 0.1 to 8.0, and more preferably 0.2 to 7.0, with respect to the charge-transporting substance 1.

Moreover, the viscosity of the charge-transporting composition used in the present invention is appropriately adjusted in accordance with coating method, in consideration of the thickness and the like of the thin film to be produced and the solid content concentration, and is usually about 0.1 to 50 mPa·s at 25°C.

In preparing the charge-transporting composition of the present invention, the charge-transporting substance, the organosilane compound, the electron accepting dopant substance, the solvent and the like can be mixed in any order as long as the solid content is uniformly dissolved or dispersed in the solvent. That is, for example, any of a method in which the polythiophene derivative is dissolved in the solvent as the conductive polymer and then the electron accepting dopant substance is dissolved in the solution, a method in which the electron accepting dopant substance is dissolved in the solvent and then the polythiophene derivative is dissolved in the solution, and a method in which the polythiophene derivative and the electron accepting dopant substance are mixed and then the mixture thereof is charged into the solvent and dissolved can be adopted as long as the solid content is uniformly dissolved or dispersed in the solvent.

In addition, usually, the preparation of the charge-transporting composition is carried out in an inert gas atmosphere at normal temperature and normal pressure, but may be carried out in an atmospheric air (in the presence of oxygen) and may be carried out while heating unless the compound in the composition is decomposed or the composition is greatly changed.

The hole collecting layer of the present invention can be formed by applying the charge-transporting composition described above onto an anode in the case of a normal lamination type perovskite solar cell, or onto an active layer in the case of an inverse lamination type perovskite solar cell, and baking the composition, but a preferred aspect in the present invention is a normal lamination type.

In coating, an optimum method may be adopted from various wet process methods such as drop casting, spin coating, blade coating, dip coating, roll coating, bar coating, die coating, ink jet methods and printing methods (letterpress, intaglio, lithography, screen printing, etc.), in consideration of viscosity and surface tension of the composition, desired thickness of the thin film, and the like.

In addition, usually, the coating is carried out in an inert gas atmosphere at normal temperature and normal pressure, but may be carried out in an atmospheric air (in the presence of oxygen) and may be carried out while heating unless the compound in the composition is decomposed or the composition is greatly changed.

The film thickness is not particularly limited, but, in any case, is preferably about 0.1 to 500 nm, and further preferably about 1 to 100 nm. As a method of changing the film thickness, there are a method of changing the solid content concentration in the composition, and a method of changing a solution amount at the time of application.

Hereinafter, a method for producing a perovskite solar cell using the charge-transporting composition of the present invention as a composition for forming a hole collecting layer is described, but the method is not limited thereto.

(1) Normal Lamination Type Perovskite Solar Cell [Formation of Anode Layer]: Step of forming a layer of anode material on a surface of a transparent substrate to produce a transparent electrode

As the anode material, inorganic oxides such as indium tin oxide (ITO) and indium zinc oxide (IZO), metals such as gold, silver, and aluminum, and highly charge-transporting organic compounds such as polythiophene derivatives and polyaniline derivatives can be used. Among them, ITO is most preferable. Further, as the transparent substrate, a substrate made of glass or a transparent resin can be used.

The method for forming a layer of anode material (anode layer) is appropriately selected according to properties

of the anode material. Usually, in the case of a poorly soluble or poorly dispersible sublimable material, a dry process such as vacuum deposition or sputtering is selected, and in the case of a solution material or a dispersion material, an optimum method is adopted from the various wet process methods described above, in consideration of the viscosity and surface tension of the composition, the desired thickness of the thin film, and the like.

Moreover, a commercially available transparent anode substrate can also be used, and in this case, it is preferable to use a smoothed substrate, from the viewpoint of improving the yield of the element. When using a commercially available transparent anode substrate, the method for producing a perovskite solar cell of the present invention does not include a step of forming an anode layer.

When forming a transparent anode substrate using an inorganic oxide such as ITO as the anode material, it is preferable to wash it with a detergent, an alcohol, pure water or the like before laminating an upper layer before use. Furthermore, it is preferable to perform surface treatment such as UV ozone treatment or oxygen-plasma treatment immediately before use. Surface treatment may not be carried out when the anode material contains organic matter as a principal component.

[Formation of Hole Collecting Layer]: Step of forming a hole collecting layer on the layer of anode material formed

In accordance with the above method, the charge-transporting composition of the present invention is used to form a hole collecting layer on the layer of anode material.

[Formation of Active Layer]: Step of forming an active layer on the hole collecting layer formed

In the present invention, an active layer containing a perovskite semiconductor compound is used as the active layer.

The perovskite semiconductor compound refers to a semiconductor compound having a perovskite structure. As the perovskite semiconductor compound, a known compound can be used, and is not particularly limited, and examples thereof include compounds represented by general formula $A^+M^{2+}X^-_3$ and compounds represented by general formula $A^+_2 M^{2+}X^-_4$. Here, $A^+$ represents a monovalent cation, $M^{2+}$ represents a divalent cation, and $X^-$ represents a monovalent anion.

Examples of the monovalent cation $A^+$ include cations containing Groups 1 and 13 to 16 elements of the periodic table. Among them, a cesium ion, a rubidium ion, an ammonium ion which may have a substituent, or a phosphonium ion which may have a substituent is preferable.

Examples of the ammonium ion which may have a substituent include a primary ammonium ion and a secondary ammonium ion. The substituent is not particularly limited, but is preferably an alkylammonium ion or an arylammonium ion. In particular, in order to avoid steric hindrance, a monoalkylammonium ion with a three-dimensional crystal structure is more preferable. The number of carbon atoms of the alkyl group contained in the alkylammonium ion is preferably 1 to 30, more preferably 1 to 20, and further preferably 1 to 10. The number of carbon atoms of the aryl group contained in the arylammonium ion is preferably 6 to 30, more preferably 6 to 20, and further preferably 6 to 12.

Specific examples of the monovalent cation $A^+$ include a methylammonium ion, an ethylammonium ion, an isopropylammonium ion, an n-propylammonium ion, an isobutylammonium ion, an n-butylammonium ion, a t-butylammonium ion, a dimethylammonium ion, a diethylammonium ion, a phenylammonium ion, a benzylammonium ion, a phenethylammonium ion, a guanidinium ion, a formamidinium ion, an acetamidinium ion, an imidazolium ion, and the like. The cations $A^+$ can be used singly or in combination of two or more kinds thereof.

The divalent cation $M^{2+}$ is preferably a divalent metal cation or a metalloid cation, and more preferably a cation of a Group 14 element of the periodic table. Specific examples of the divalent cation M include a lead cation ($Pb^{2+}$), a tin cation ($Sn^{2+}$), a germanium cation ($Ge^{2+}$) and the like. In the present invention, it is preferable to contain a lead cation from the viewpoint of obtaining a photoelectric conversion element excellent in stability. The cations $M^{2+}$ can be used singly or in combination of two or more kinds thereof.

Examples of the monovalent anion $X^-$ include a halide ion, an acetate ion, a nitrate ion, an acetylacetonate ion, a thiocyanate ion, a 2,4-pentanedionato ion, and the like, and a halide ion is preferable. The anions $X^-$ can be used singly or in combination of two or more kinds thereof.

Examples of the halide ion include a chloride ion, a bromide ion, an iodide ion, and the like. In the present invention, it is preferable to contain iodide ions, from the viewpoint of preventing a band gap of the semiconductor from being excessively widened.

As the perovskite semiconductor compound, for example, an organic-inorganic perovskite semiconductor compound is preferable, and a halide-based organic-inorganic perovskite semiconductor compound is more preferable. Specific examples of the perovskite semiconductor compound include $CH_3NH_3PbI_3$, $CH_3NH_3PbBr_3$, $CH_3NH_3PbCl_3$, $CH_3NH_3SnI_3$, $CH_3NH_3SnBr_3$, $CH_3NH_3SnCl_3$, $CH_3NH_3PbI_{(3-x)}Cl_x$, $CH_3NH_3PbI_{(3-x)}Br_x$, $CH_3NH_3PbBr_{(3-x)}Cl_x$, $CH_3NH_3Pb_{(1-y)}Sn_yI_3$, $CH_3NH_3Pb_{(1-y)}Sn_yBr_3$, $CH_3NH_3Pb_{(1-y)}Sn_yCl_3$, $CH_3NH_3Pb_{(1-y)}Sn_yI_{(3-x)}Cl_x$,

$CH_3NH_3Pb_{(1-y)}Sn_yI_{(3-x)}Br_x$, $CH_3NH_3Pb_{(1-y)}Sn_yBr_{(3-x)}Cl_x$, and the like. Meanwhile, x represents an arbitrary number of 0 to 3, and y represents an arbitrary number of 0 to 1.

From the viewpoint of improving photoelectric conversion efficiency, it is preferable to use a semiconductor compound with an energy band gap of 1.0 to 3.5 eV as the perovskite semiconductor compound.

The active layer may contain two or more perovskite semiconductor compounds. For example, the active layer may contain two or more perovskite semiconductor compounds in which at least one of $A^+$, $M^{2+}$, and $X^-$ above is different.

The content of the perovskite semiconductor compound in the active layer is preferably 50 wt% or more, more preferably 70 wt% or more, and still more preferably 80 wt% or more, from the viewpoint of obtaining good photoelectric conversion characteristics. The upper limit is not particularly limited, but is usually 100 wt% or less.

In addition, the active layer may contain other additives as necessary. Examples of the additive that can be used in the present invention include a surfactant, a charge imparting agent, 1,8-diiodooctane, N-cyclohexyl-2 pyrrolidone, and the like.

The content of these additives in the active layer is preferably 50 wt% or less, more preferably 30 wt% or less, and still more preferably 20 wt% or less, from the viewpoint of obtaining good PCE. The lower limit is not particularly limited, but is usually 0 wt% or more.

Also as for the method for forming the active layer, similarly as described above, an optimum method is adopted from the various wet process methods described above, in consideration of the viscosity and surface tension of the composition, the desired thickness of the thin film, and the like.

[Formation of Electron Collecting Layer]: Step of forming an electron collecting layer on the active layer formed

If necessary, an electron collecting layer may be formed between the active layer and a cathode layer, for the purpose of improving efficiency of charge transfer and the like.

Examples of the material for forming the electron collecting layer include fullerenes, lithium oxide ($Li_2O$), magnesium oxide (MgO), alumina ($Al_2O_3$), lithium fluoride (LiF), sodium fluoride (NaF), magnesium fluoride ($MgF_2$), strontium fluoride ($SrF_2$), cesium carbonate ($Cs_2CO_3$), 8-quinolinol lithium salt (Liq), 8-quinolinol sodium salt (Naq), bathocuproine (BCP), 4,7-diphenyl-1,10-phenanthroline (BPhen), polyethyleneimine (PEI), ethoxylated polyethyleneimine (PEIE), and the like.

As the fullerenes, fullerenes and derivatives thereof are preferable, but the fullerenes are not particularly limited. Specific examples thereof include fullerenes having C60, C70, C76, C78, C84 or the like as a basic skeleton and derivatives thereof. In the fullerene derivative, a carbon atom in the fullerene skeleton may be modified with an arbitrary functional group, and the functional groups may be bonded to each other to form a ring. The fullerene derivative includes fullerene-bonded polymers. A fullerene derivative with a functional group having high affinity for a solvent and with high solubility in a solvent is preferable.

Examples of the functional group in the fullerene derivative include a hydrogen atom, a hydroxyl group, halogen atoms such as a fluorine atom and a chlorine atom, alkyl groups such as a methyl group and an ethyl group, alkenyl groups such as a vinyl group, alkoxy groups such as a cyano group, a methoxy group, and an ethoxy group, aromatic hydrocarbon groups such as a phenyl group and a naphthyl group, aromatic heterocyclic groups such as a thienyl group and a pyridyl group, and the like. Specific examples thereof include hydrogenated fullerenes such as C60H36 and C70H36, oxide fullerenes such as C60 and C70, fullerene metal complexes, and the like. As the fullerene derivative, it is more preferable to use [6,6]-phenyl C61 butyric acid methyl ester ([60]PCBM) or [6,6]-phenyl C71 butyric acid methyl ester ([70]PCBM).

Also as for the method for forming the electron collecting layer, similarly as described above, in a case where the electron collecting material is a poorly soluble sublimable material, the various dry processes described above are selected, and in the case of a solution material or a dispersion material, an optimum method is adopted from the various wet process methods described above, in consideration of the viscosity and surface tension of the composition, the desired thickness of the thin film, and the like.

[Formation of Cathode Layer]: Step of forming a cathode layer on the electron collecting layer formed

Examples of the cathode material include metals such as aluminum, magnesium-silver alloy, aluminum-lithium alloy, lithium, sodium, potassium, cesium, calcium, barium, silver, and gold; inorganic compounds such as indium tin oxide (ITO) and indium zinc oxide (IZO); and highly charge-transporting organic compounds such as polythiophene derivatives and polyaniline derivatives, and a plurality of cathode materials can be laminated or mixed and used.

Also as for the method for forming the cathode layer, similarly as described above, in a case where the cathode layer material is a poorly soluble or poorly dispersible sublimable material, the various dry processes described above are selected, and in the case of a solution material or a dispersion material, an optimum method is adopted from the various wet process methods described above, in consideration of the viscosity and surface tension of the composition,

the desired thickness of the thin film, and the like.

[Formation of Carrier Blocking Layer]

If necessary, a carrier blocking layer may be provided between arbitrary layers for the purpose of controlling rectifying properties of photocurrent, and the like. When the carrier blocking layer is provided, usually, an electron blocking layer is inserted between the active layer and the hole collecting layer or the anode, and a hole blocking layer is inserted between the active layer and the electron collecting layer or the cathode in many cases, but the present invention is not limited thereto.
Examples of the material for forming the hole blocking layer include titanium oxide, zinc oxide, tin oxide, bathocuproine (BCP), 4,7-diphenyl 1,10-phenanthroline (BPhen), and the like.
Examples of the material for forming the electron blocking layer include triarylamine-based materials such as N,N'-di(1-naphthyl)-N,N'-diphenylbenzidine (a-NPD) and poly(triarylamine) (PTAA), and the like.
Also as for the method for forming the carrier blocking layer, similarly as described above, in a case where the carrier blocking layer material is a poorly soluble or poorly dispersible sublimable material, the various dry processes described above are selected, and in the case of a solution material or a dispersion material, an optimum method is adopted from the various wet process methods described above, in consideration of the viscosity and surface tension of the composition, the desired thickness of the thin film, and the like.

(2) Inverse Lamination Type Perovskite Solar Cell

[Formation of Cathode Layer]: Step of forming a layer of cathode material on the surface of a transparent substrate to produce a transparent cathode substrate

Examples of the cathode material include fluorine-doped tin oxide (FTO) in addition to those exemplified for the anode material for the normal lamination type, and examples of the transparent substrate include those exemplified as the anode materials for the normal lamination type.
Also as for the method for forming the layer of cathode material (cathode layer), in the case of a poorly soluble or poorly dispersible sublimable material, the dry processes described above are selected, and in the case of a solution material or a dispersion material, an optimum method is adopted from the various wet process methods described above, in consideration of the viscosity and surface tension of the composition, the desired thickness of the thin film, and the like.
Also in this case, a commercially available transparent cathode substrate can be suitably used, and it is preferable to use a smoothed substrate, from the viewpoint of improving the yield of the element. When using a commercially available transparent cathode substrate is used, the method for producing a perovskite solar cell of the present invention does not include the step of forming a cathode layer.
When an inorganic oxide is used as the cathode material to form a transparent cathode substrate, washing treatment or surface treatment similar to that of the anode material for the normal lamination type may be applied.

[Formation of Electron Collecting Layer]: Step of forming an electron collecting layer on the cathode formed

If necessary, an electron collecting layer may be formed between the active layer and the cathode layer, for the purpose of improving efficiency of charge transfer and the like.
Examples of the material for forming the electron collecting layer include zinc oxide (ZnO), titanium oxide (TiO), tin oxide (SnO), and the like, in addition to those exemplified as the materials for the normal lamination type.
Also as for the method for forming the electron collecting layer, in the case of a poorly soluble or poorly dispersible sublimable material, the dry processes described above are selected, and in the case of a solution material or a dispersion material, an optimum method is adopted from the various wet process methods described above, in consideration of the viscosity and surface tension of the composition, the desired thickness of the thin film, and the like. It is also possible to adopt a method of forming a precursor layer of an inorganic oxide on the cathode by a wet process (in particular, spin coating or slit coating) and baking it to form a layer of inorganic oxide.

[Formation of Active Layer]: Step of forming an active layer on the electron collecting layer formed

As the active layer, the active layer containing a perovskite semiconductor compound described above is formed.
The method for forming the active layer is also similar to the method described for the normal lamination type active layer.

[Formation of Hole Collecting Layer]: Step of forming a hole collecting layer on the layer of active layer material formed

In accordance with the above method, the composition of the present invention is used to form a hole collecting layer on the layer of active layer material.

[Formation of Anode Layer]: Step of forming an anode layer on the hole collecting layer formed

Examples of the anode material include those similar to the anode material for the normal lamination type, and the method for forming the anode layer is also similar to that of the normal lamination type cathode layer.

[Formation of Carrier Blocking Layer]

As is the case with a normal lamination type element, if necessary, a carrier blocking layer may be provided between arbitrary layers for the purpose of controlling rectifying properties of photocurrent, and the like.
Examples of the material for forming the hole blocking layer and the material for forming the electron blocking layer include those similar to the above, and the method for forming the carrier blocking layer is also similar to the above.
In order to prevent element degradation due to the atmosphere, the perovskite solar cell element prepared by the method exemplified above can be introduced again into a glove box and sealed under an inert gas atmosphere such as nitrogen to exhibit a function as a solar cell in a sealed state or measure solar cell characteristics.
Examples of the sealing method include a method in which a concave glass substrate having a UV curable resin attached to an end part is adhered to a film forming surface side of a perovskite solar cell element under an inert gas atmosphere, and the resin is cured by UV irradiation, and a method in which sealing of film-seal type is carried out by a technique such as sputtering under vacuum.

## EXAMPLES

Hereinafter, the present invention is described more specifically with reference to Examples and Comparative Examples, but the present invention is not limited to the following Examples. In addition, the apparatuses used are as follows.

(1) Solar simulator: OTENTOSUN-III, manufactured by Bunkoukeiki Co.,Ltd.
(2) Source measure unit: 2401, manufactured by Keithley Instruments
(3) Film thickness measuring apparatus: DEKTAK XT, manufactured by Bulker Corporation
(4) Photoelectron spectrometer: AC-2, manufactured by Riken Keiki Co., Ltd.

Preparation of Composition for Hole Collecting Layer

[Example 1-1]

2,462 mg of PEDOT-PSS (manufactured by Heraeus, model number AI4083, PEDOT : PSS = 1 : 6, solid content concentration: 1.3 to 1.7 wt%) was dissolved in 2,425 mg of ethanol, and 113 mg of TEOS (manufactured by TAMA CHEMICALS CO., LTD.) was added thereto to prepare a dark blue solution. The resulting dark blue liquid was filtered through a 0.45 $\mu$m syringe filter to obtain a composition A for a hole collecting layer (solid content concentration: 3.0 wt%).
Meanwhile, the solid content concentration is a value calculated by setting the solid content concentration of PEDOT : PSS to 1.5 wt% and using the total amount of TEOS as the solid content (hereinafter, the same shall apply).

[Example 1-2]

A composition B for a hole collecting layer (solid content concentration: 2.3 wt%) was obtained in the same manner as in Example 1 except that the TEOS amount was changed to 80 mg.

[Example 1-3]

A composition C for a hole collecting layer (solid content concentration: 1.9 wt%) was obtained in the same manner as in Example 1 except that the TEOS amount was changed to 60 mg.

[Example 1-4]

A composition D for a hole collecting layer (solid content concentration: 1.3 wt%) was obtained in the same manner as in Example 1 except that the TEOS amount was changed to 30 mg.

Preparation and Evaluation of Perovskite Solar Cell

[Example 2-1]

Lead iodide ($PbI_2$) and methylammonium iodide ($CH_3NH_3I$) were each dissolved in dimethyl sulfoxide (DMSO) at a concentration of 1 M to prepare a perovskite precursor solution.

On the other hand, the composition A for a hole collecting layer was applied onto a glass substrate on which a positive electrode made of indium tin oxide (ITO) with a film thickness of 100 nm was formed by spin coating, and annealed at 200°C to form a hole collecting layer A with a film thickness of 71 nm. The substrate on which the hole collecting layer was formed was carried into a glove box substituted with nitrogen. Then, the precursor solution prepared above was dropped onto the hole collecting layer A through a filter with a pore size of 0.45 μm, and the substrate was rotated at 500 rpm for 10 seconds and then rotated at 6,000 rpm for 30 seconds to be spin-coated, thereby forming a perovskite precursor film. Next, the temperature of an immersion tank filled with deoxygenated toluene (second solvent) was adjusted to 25°C on a cool plate. While stirring the solvent, the substrate on which the perovskite precursor film was formed was immersed in the solvent for 2 minutes. Thereafter, the substrate was taken out and annealed at 90°C for 5 minutes, thereby producing a perovskite film. On the perovskite film, two organic layers and an electrode were formed at a degree of vacuum of $1 \times 10^{-4}$ Pa by vacuum deposition. First, fullerene ($C_{60}$) was deposited on the perovskite film in a thickness of 30 nm, and BCP was deposited thereon in a thickness of 10 nm to form a two-layer organic layer. Furthermore, Ag was deposited thereon in a thickness of 100 nm to form an electrode. The resulting laminate (substrate/ITO positive electrode/hole collecting layer/perovskite film/$C_{60}$ layer/BCP layer/Ag negative electrode) was housed in a glass sealed tube and sealed with a UV curable resin to obtain a solar cell.

[Example 2-2]

A solar cell was prepared using the same procedure as in Example 2-1 except that the composition B for a hole collecting layer was used as the hole collecting layer.

[Example 2-3]

A solar cell was prepared using the same procedure as in Example 2-1 except that the composition C for a hole collecting layer was used as the hole collecting layer.

[Example 2-4]

A solar cell was prepared using the same procedure as in Example 2-1 except that the composition D for a hole collecting layer was used as the hole collecting layer.

[Comparative Example 2-1]

A solar cell was prepared using the same procedure as in Example 2-1 except that PEDOT-PSS (manufactured by Heraeus, model number AI4083) was used as the hole collecting layer.

Characteristic Evaluation

The perovskite solar cells prepared in Examples 2-1 to 2-4 and Comparative Example 2-1 above were irradiated with AM 1.5 pseudo sunlight at an irradiance of 100 mW/cm$^2$ using a solar simulator, and short circuit current density (Jsc), open circuit voltage (Voc), fill factor (FF), and PCE were evaluated. Results are shown in Table 1.

PCE [%] was calculated by the following equation.

$$\text{PCE [\%]} = \text{Jsc [mA/cm}^2\text{]} \times \text{Voc [V]} \times \text{FF / incident light intensity (100 [mW/cm}^2\text{])} \times 100$$

[Table 1]

| | Example 2-1 | Example 2-2 | Example 2-3 | Example 2-4 | Comparative Example 2-1 |
|---|---|---|---|---|---|
| Composition for hole collecting layer | A | B | C | D | AI4083 |
| TEOS amount (PEDOT-PSS weight ratio*) | 3.1 | 2.2 | 1.6 | 0.8 | - |
| Film thickness (nm) | 71 | 60 | 55 | 55 | 30-50 |
| Jsc ($mA/cm^2$) | 16.35 ± 0.49 | | | | |
| Voc (V) | 1.04 | 1.04 | 1.00 | 0.89 | 0.86 |
| FF | 0.65 ± 0.01 | | | | |
| PCE (%) | 11.00 0.39 | 11.35 ± 0.34 | 13.65 ± 0.34 | 12.71 ± 0.26 | 10.58 ± 0.45 |
| * A value calculated by setting the solid content concentration of PEDOT-PSS to 1.5 wt%. | | | | | |

From the results in Table 1, it has been found that a perovskite solar cell having very stable characteristics can be obtained by using the composition for a hole collecting layer of the present invention.

Preparation of Substrate with Hole Collecting Layer for Evaluation of Chemical Resistance

[Example 2-5]

The composition A for a hole collecting layer was applied onto a glass substrate on which a film made of indium tin oxide (ITO) with a film thickness of 100 nm was formed by spin coating, and annealed at 200°C to form a hole collecting layer with a film thickness of 71 nm, and a substrate with a hole collecting layer was prepared. Three substrates with a hole collecting layer were prepared.

[Comparative Example 2-2]

A hole collecting layer with a film thickness of 40 nm was formed using the same procedure as in Example 2-5 except that PEDOT-PSS (manufactured by Heraeus, model number AI4083) was used as the composition for forming a hole collecting layer, and a substrate with a hole collecting layer was prepared. Three substrates with a hole collecting layer were prepared.

Evaluation of Chemical Resistance

3 mL of dimethyl sulfoxide (DMSO) was dropped onto the hole collecting layer of the substrate with a hole collecting layer prepared above and allowed to stand for 10 seconds, and then spin-coated at 6,000 rpm for 30 seconds to form a DMSO liquid film. Thereafter, the substrate was dried at 200°C for 10 minutes to prepare a DMSO-treated substrate.

Next, 3 mL of a DMSO solution of methyl ammonium iodide (MAI) adjusted to a concentration of 1 M was dropped onto the hole collecting layer of another substrate with a hole collecting layer and allowed to stand for 10 seconds, and then spin-coated at 6,000 rpm for 30 seconds to form a MAI (DMSO) liquid film on the hole collecting layer. Further, 3 mL of DMSO was dropped and allowed to stand for 10 seconds, and then rinsed by spin coating at 6,000 rpm for 30 seconds while dropping 3 mL of DMSO. Next, a MAI (DMSO)-treated substrate was prepared by drying at 200°C for 10 minutes.

For the DMSO-treated substrate, the MAI (DMSO)-treated substrate and the untreated substrate, an ionization potential of the hole collecting layer was measured using a photoelectron spectrometer. Results are shown in Table 2.

[Table 2]

| | Example 2-5 | Comparative Example 2-2 |
|---|---|---|
| Hole collecting layer | Hydrolysate of PEDOT-PSS/TEOS | PEDOT-PSS |

(continued)

| | Example 2-5 | Comparative Example 2-2 |
|---|---|---|
| Untreated | -5.22 eV | -5.23 eV |
| DMSO-treated | -5.24 eV | -5.16 eV |
| MAI (DMSO)-treated | -5.17 eV | -5.06 eV |

From the results in Table 2, in a case where the hole collecting layer was formed using the composition of Comparative Example, the ionization potential was shallower by 0.1 eV or more when exposed to MAI, whereas in the case where the hole collecting layer was formed using the composition A for a hole collecting layer, change in the ionization potential was small. A similar tendency was observed in the case of being exposed to DMSO.

**Claims**

1. A charge-transporting composition for a perovskite photoelectric conversion element comprising: a charge-transporting substance composed of a conductive polymer; an organosilane compound; and a solvent.

2. The charge-transporting composition for a perovskite photoelectric conversion element according to claim 1, wherein the conductive polymer is a p-type conjugated homopolymer.

3. The charge-transporting composition for a perovskite photoelectric conversion element according to claim 1 or 2, wherein the conductive polymer is a polythiophene derivative.

4. The charge-transporting composition for a perovskite photoelectric conversion element according to any one of claims 1 to 3, wherein the conductive polymer is a polythiophene derivative containing a repeating unit having formula (1):

[Chem. 1]

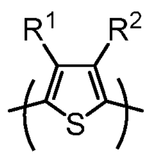

(1)

wherein $R^1$ and $R^2$ are each independently a hydrogen atom, an alkyl group having 1 to 40 carbon atoms, a fluoroalkyl group having 1 to 40 carbon atoms, an alkoxy group having 1 to 40 carbon atoms, a fluoroalkoxy group having 1 to 40 carbon atoms, an aryloxy group having 6 to 20 carbon atoms, $-O-[Z-O]_p-R^e$, or a sulfonic acid group, or are -O-Y-O- formed by bonding $R^1$ and $R^2$, Y is an alkylene group having 1 to 40 carbon atoms which may contain an ether bond and may be substituted with a sulfonic acid group, Z is an alkylene group having 1 to 40 carbon atoms which may be substituted with a halogen atom, p is 1 or more, $R^e$ is a hydrogen atom, an alkyl group having 1 to 40 carbon atoms, a fluoroalkyl group having 1 to 40 carbon atoms, or an aryl group having 6 to 20 carbon atoms.

5. The charge-transporting composition for a perovskite photoelectric conversion element according to any one of claims 1 to 4, wherein the organosilane compound is alkoxysilane.

6. The charge-transporting composition for a perovskite photoelectric conversion element according to claim 5, wherein the alkoxysilane contains at least one selected from trialkoxysilane and tetraalkoxysilane.

7. The charge-transporting composition for a perovskite photoelectric conversion element according to any one of claims 1 to 6, wherein the charge-transporting composition is for a hole collecting layer of a perovskite photoelectric conversion element.

8. The charge-transporting composition according to claim 7, wherein the perovskite photoelectric conversion element

is a solar cell.

**9.** A thin film obtained from the charge-transporting composition for a perovskite photoelectric conversion element according to any one of claims 1 to 6.

**10.** The thin film according to claim 9, wherein the thin film is a hole collecting layer of a perovskite photoelectric conversion element.

**11.** A perovskite photoelectric conversion element comprising the thin film according to claim 9 or 10.

**12.** A perovskite photoelectric conversion element comprising: the hole collecting layer according to claim 10; and an active layer provided so as to be in contact with the hole collecting layer, the active layer containing a perovskite semiconductor compound.

**13.** A perovskite photoelectric conversion element comprising: a pair of electrodes; an active layer provided between the pair of electrodes; and a hole collecting layer provided between the active layer and the electrodes,
the active layer containing a perovskite semiconductor compound, and the hole collecting layer being the thin film according to claim 10.

**14.** A solar cell comprising the perovskite photoelectric conversion element according to any one of claims 11 to 13.

## INTERNATIONAL SEARCH REPORT

International application No.
PCT/JP2020/000966

A. CLASSIFICATION OF SUBJECT MATTER
H01L 51/44(2006.01)i; C08K 5/541(2006.01)i; C08L 65/00(2006.01)i; H01L 51/46(2006.01)i
FI: H01L31/04 112Z; H01L31/04 168; C08K5/541; C08L65/00
According to International Patent Classification (IPC) or to both national classification and IPC

B. FIELDS SEARCHED
Minimum documentation searched (classification system followed by classification symbols)
H01L51/42-51/48; C08K5/541; C08L65/00

Documentation searched other than minimum documentation to the extent that such documents are included in the fields searched

| | |
|---|---|
| Published examined utility model applications of Japan | 1922-1996 |
| Published unexamined utility model applications of Japan | 1971-2020 |
| Registered utility model specifications of Japan | 1996-2020 |
| Published registered utility model applications of Japan | 1994-2020 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| X | JP 2018-505542 A (HERAEUS DEUTSCHLAND GMBH & CO. KG) 22.02.2018 (2018-02-22) paragraphs [0010], [0036]-[0114], fig. 1-3 | 1-14 |
| A | CN 109065726 A (TAIYUAN UNIVERSITY OF TECHNOLOGY) 21.12.2018 (2018-12-21) paragraphs [0004]-[0010] | 1-14 |
| P, X | WO 2019/176662 A1 (NISSAN CHEMICAL CORPORATION) 19.09.2019 (2019-09-19) paragraphs [0009], [0073] | 1-10 |

☐ Further documents are listed in the continuation of Box C. ☒ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 19 March 2020 (19.03.2020) | 31 March 2020 (31.03.2020) |
| Name and mailing address of the ISA/ Japan Patent Office 3-4-3, Kasumigaseki, Chiyoda-ku, Tokyo 100-8915, Japan | Authorized officer<br>Telephone No. |

Form PCT/ISA/210 (second sheet) (January 2015)

**INTERNATIONAL SEARCH REPORT**
Information on patent family members

International application no.
PCT/JP2020/000966

| Patent Documents referred in the Report | Publication Date | Patent Family | Publication Date |
|---|---|---|---|
| JP 2018-505542 A | 22 Feb. 2018 | US 2017/0365418 A1<br>paragraphs [0060]-[0200], fig. 1-3<br>WO 2016/079145 A1<br>EP 3024042 A1<br>TW 201624738 A<br>CN 107001596 A<br>KR 10-2017-0086613 A | |
| CN 109065726 A | 21 Dec. 2018 | (Family: none) | |
| WO 2019/176662 A1 | 19 Sep. 2019 | (Family: none) | |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2016178193 A


### Non-patent literature cited in the description


- *Nature,* 1991, vol. 353, 737-740
- *Appl. Phys. Lett.,* 1986, vol. 48, 183-185